# EUROPEAN PATENT SPECIFICATION

(11) **EP 2 759 557 B1**
(45) Date of publication and mention of the grant of the patent: **03.02.2016**
(21) Application number: 11872853.4
(22) Date of filing: 23.09.2011
(51) Int. Cl.: C08G 61/12, H01L 51/46, H01L 51/00, H01L 51/42, H01L 31/0216

(54) **FLUORENE-CONTAINING DIFLUORO BENZOTRIAZOLYL COPOLYMER AND PREPARATION METHOD AND USE THEREOF**
FLUORENHALTIGES DIFLUORBENZOTRIAZOLYL-COPOLYMER, VERFAHREN ZU SEINER HERSTELLUNG UND VERWENDUNG
COPOLYMÈRE DE DIFLUOROBENZOTRIAZOLYLE CONTENANT DU FLUORÈNE ET SON PROCÉDÉ DE PRÉPARATION ET SON UTILISATION

(43) Date of publication of application: 30.07.2014
(73) Proprietor: Ocean's King Lighting Science&Technology Co., Ltd., Guangdong 518054 (CN)
(72) Inventor: ZHOU, Mingjie, Shenzhen Guangdong 518054 (CN); WANG, Ping, Shenzhen Guangdong 518054 (CN); ZHANG, Zhenhua, Shenzhen Guangdong 518054 (CN); LIANG, Lusheng, Shenzhen Guangdong 518054 (CN)
(74) Representative: Johnson, Richard Alan
(86) International application number: PCT/CN2011/080102
(87) International publication number: WO 2013/040786

(56) References cited:
- WO-A2-2010/046114
- LIU, BO ET AL.: 'A dithienyl benzotriazole-based polyfluorene: synthesis and applications in polymer solar cells and red light-emitting diodes.' MACROMOLECULAR CHEMISTRY AND PHYSICS vol. 212, no. 14, 15 July 2011, pages 1489 - 1496, XP055048098
- KAYA, E. ET AL.: 'Electrochromic and optical studies of solution processable benzotriazole and fluorene containing copolymers.' ORGANIC ELECTRONICS vol. 12, no. 1, January 2011, pages 202 - 209, XP027577007
- ZHANG, LIANJIE ET AL.: 'Bulk-heterojunction solar cells with benzotriazole-based copolymers as electron donors: largely improved photovoltaic parameters by using PFN/Al bilayer cathode.' MACROMOLECULES vol. 43, no. 23, 2010, pages 9771 - 9778, XP055048110
- PRICE, S.C. ET AL.: 'Fluorine Substituted Conjugated Polymer of Medium Band Gap Yields 7% Efficiency in Polymer-Fullerene Solar Cells.' JOURNAL OF THE AMERICAN CHEMICAL SOCIETY vol. 133, no. 12, 04 March 2011, pages 4625 - 4631, XP002665448

## Description

### FIELD OF THE INVENTION

The present invention related to the field of materials of solar cells, particularly to fluorene-containing difluoro benzotriazolyl copolymer and preparation method and use thereof.

### BACKGROUND OF THE INVENTION

A persistent difficulty and hotspot in the field of photovoltaics is to prepare low-cost, high-energy solar cells using cheap materials. Currently, the application of crystalline silicon cell used for the ground is greatly confined because of its complicated process and high cost. In order to reduce the cost of the battery, it has been a long time for people to seek for a new solar cell material to cut the cost and expand the application. Organic semiconductor material has attracted considerable attention owing to its advantages of available raw material, low cost, simple process, good environmental stability and good photovoltaic effect. Since photo-induced electron transfer phenomenon between conjugated polymer and C₆₀ was reported on Science (N. S Sariciftci, L. S milowitz, A. J. Heeger, et al. Science, 1992, 258, 1474) by N. S. Sariciftci, et al. in 1992, considerable efforts have been directed toward developing polymer solar cells, and a rapid development is achieved. However, the conversion efficiency is much lower than that of inorganic solar cells.

### SUMMARY OF THE INVENTION

The purpose of the present invention is to provide fluorene-containing difluoro benzotriazolyl copolymer having high power conversion efficiency.

A fluorene-containing difluoro benzotriazolyl copolymer, wherein having a structure represented by the following formula (I): 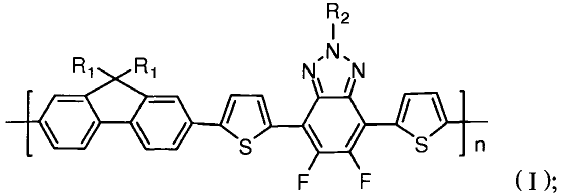 wherein R₁ and R₂ are alkyls from C₁ to C₂₀, and n is an integer from 10 to 100.

In preferred embodiments, n is in a preferred range of 50∼70.

Another purpose of the present invention is to provide a method for preparing the above fluorene-containing difluoro benzotriazolyl copolymer, comprising:

S 1, providing compound A and compound B represented by the following formulas, separately; 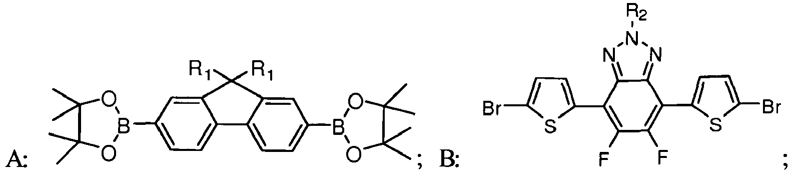 wherein in said compound A, R₁ is alkyl from C₁ to C₂₀; in said compound B, R₂ is alkyl from C₁ to C₂₀;

S2, in an oxygen-free environment, adding said compound A and compound B in a molar ratio of 1:1 into organic solvent containing catalyst and alkaline solution, carrying out Suzuki coupling reaction at a temperature in the range of 70 to 130°C for 12 to 96 h, then obtaining fluorene-containing difluoro benzotriazolyl copolymer having a structure represented by the following formula (I): 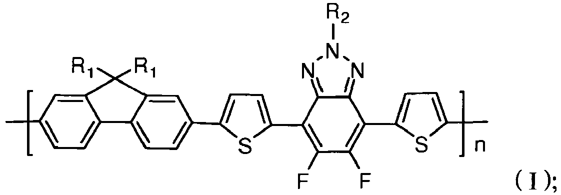 wherein n is an integer from 10 to 100.

The method for preparing fluorene-containing difluoro benzotriazolyl copolymer further comprises the step of:

S3, purifying the fluorene-containing difluoro benzotriazolyl copolymer obtained in S2.

In the S2 of the above method for preparing fluorene-containing difluoro benzotriazolyl copolymer:

The catalyst is organopalladium or mixture of organopalladium and organic phosphorus ligand; molar ratio of the organopalladium to the compound A is in the range of 1:20∼1:100.

The organic solvent comprises at least one solvent selected from the group consisting of methylbenzene, N,N-dimethylformamide and tetrahydrofuran.

The alkaline solution comprises at least one alkaline solution selected from the group consisting of sodium carbonate solution, potassium carbonate solution and sodium bicarbonate solution.

Preferably, in the S2:
The Suzuki coupling reaction is carried out at a temperature in the range of 80 to 110°C for 24 to 72 h.

Yet another purpose of the present invention is to provide uses of the above fluorene-containing difluoro benzotriazolyl copolymer in organic solar cells.

In the fluorene-containing difluoro benzotriazolyl copolymer of the present invention, because the 1, 2, 3-benzotriazole polymer contains two fluorine atoms, the HOMO energy level will be reduced by 0.11 eV while the fluorine-substituted 1, 2, 3-benzotriazole has two imido groups with strong electron -withdrawing property; the difluoro benzotriazole is a heterocyclic compound with strong electron-withdrawing property, and an alkyl chain can be easily introduced to the N-position of the N-H bond of the benzotriazole; the functional group of the alkyl chain can improve solar power conversion efficiency, thus solving the low efficiency problem of polymer solar cells. Meanwhile, the functional group of the alkyl chain can regulate the solubility of fluorene-containing difluoro benzotriazolyl copolymer to make the film processing easier, thus promoting its widespread use in polymer solar cells field.

### BRIEF DESCRIPTION OF THE DRAWINGS

Fig. 1 is a flow chart showing the preparation of fluorene-containing difluoro benzotriazolyl copolymer of the present invention;
Fig. 2 is a UV-VIS absorption spectrum of poly{9, 9-di-n-hexyl-2,7-fluorene-co-2-n-octyl-4,7-dithienyl-5,6-difluoro benzotriazole} prepared in Example 1.
Fig. 3 is a structure diagram of organic solar cell.

### DETAILED DESCRIPTION OF ILLUSTRATED EMBODIMENTS

The present invention provides a fluorene-containing difluoro benzotriazolyl copolymer, wherein having a structure represented by the following formula (I): 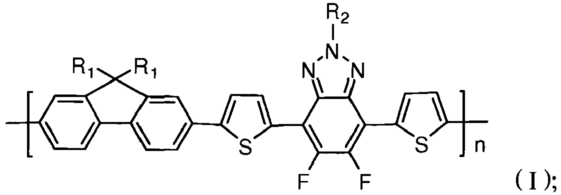 wherein R₁ and R₂ are alkyls from C₁ to C₂₀, and n is an integer from 10 to 100; preferably, n is in the range of 50∼70.

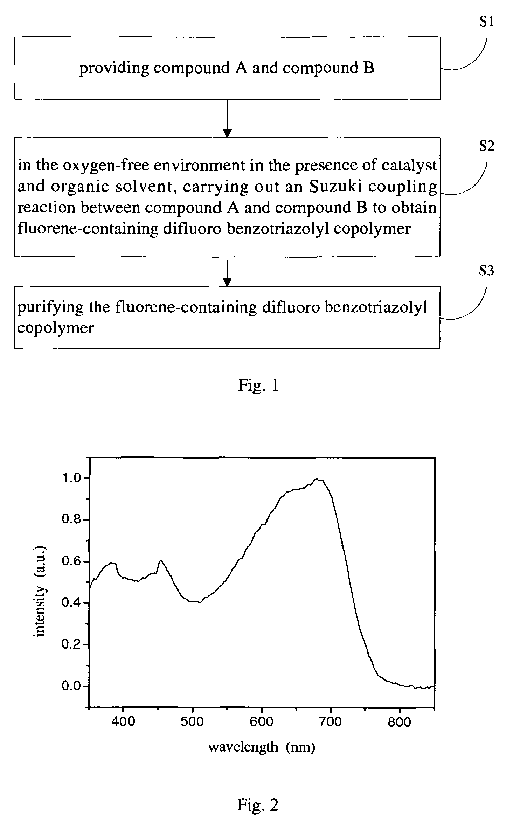

As shown in Fig. 1, a method for preparing the above fluorene-containing difluoro benzotriazolyl copolymer, comprising:

S1, providing compound A and compound B represented by the following formulas, separately; 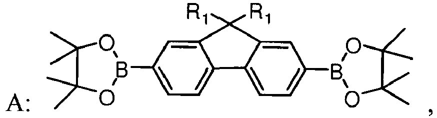 that is 2,7-bis(boronic acid pinacol ester)-9,9-dialkyl fluorene; 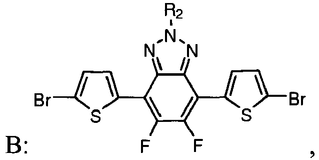 that is 2-alkyl-4, 7-bis(5-bromothienyl)-5,6-difluoro-1, 2, 3-benzotriazole;

wherein in compound A, R₁ is alkyl from C₁ to C₂₀; in compound B, R₂ is alkyl from C₁ to C₂₀;

S2, in an oxygen-free environment (such as oxygen-free environment formed by nitrogen, argon, or mixed gases of nitrogen and argon), adding said compound A and compound B in a molar ratio of 1:1 into organic solvent containing catalyst and alkaline solution, carrying out Suzuki coupling reaction at a temperature in the range of 70 to 130°C for 12 to 96 h, then obtaining reaction liquid comprising reaction product, i.e. fluorene-containing difluoro benzotriazolyl copolymer having a structure represented by the following formula (I): 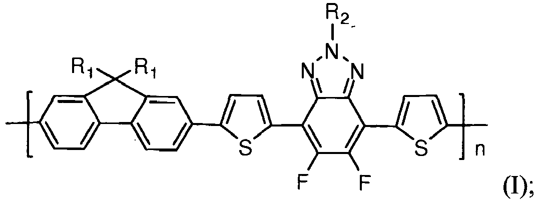 wherein n is an integer from 10 to 100.

S3, purifying the product obtained in S2:
Methanol is added to the reaction liquid of S2 to precipitate. Then the reaction liquid is filtered with Soxhlet extractor, followed by extraction with methanol and n-hexane successively for 24 h; then using chloroform as an extractant to extract until the reaction solution become colorless. Chloroform solution is collected and evaporated to give red powders. The red powders are then dried at 50°C under vacuum for 24 h to obtain purified fluorene-containing difluoro benzotriazolyl copolymer.

In the S2 of the above method for preparing fluorene-containing difluoro benzotriazolyl copolymer:
The catalyst is organopalladium, such as bis(triphenylphosphine)palladium(II) dichloride, tris(dibenzylideneacetone)dipalladium or tetrakis(triphenylphosphine)palladium(0); the catalyst can also be mixture of organopalladium and organic phosphorus ligand, such as mixture of tris(dibenzylideneacetone)dipalladium and tri-tert-butylphosphine; molar ratio of the organopalladium to the compound A is in the range of 1:20∼1:100, in the mixture of organopalladium and organic phosphorus ligand, molar ratio of organopalladium to organic phosphorus ligand is in the range of 1:3∼1:6.

The organic solvent comprises at least one solvent selected from the group consisting of methylbenzene, N,N-dimethylformamide and tetrahydrofuran.

The alkaline solution comprises at least one alkaline solution selected from the group consisting of sodium carbonate solution, potassium carbonate solution and sodium bicarbonate solution.

Preferably, in the S2:
The Suzuki coupling reaction is carried out at a temperature in the range of 80 to 110°C for 24 to 72 h.

In the fluorene-containing difluoro benzotriazolyl copolymer of the present invention, because the 1, 2, 3-benzotriazole polymer contains two fluorine atoms, the HOMO energy level will be reduced by 0.11 eV while the fluorine-substituted 1, 2, 3-benzotriazole has two imido groups with strong electron -withdrawing property; the difluoro benzotriazole is a heterocyclic compound with strong electron-withdrawing property, and an alkyl chain can be easily introduced to the N-position of the N-H bond of the benzotriazole; the functional group of the alkyl chain can improve solar power conversion efficiency, thus solving the low efficiency problem of polymer solar cells. Meanwhile, the functional group of the alkyl chain can regulate the solubility of fluorene-containing difluoro benzotriazolyl copolymer to make the film processing easier, thus promoting its widespread use in polymer solar cells field.

Moreover, in the preparation method of the present invention, simple synthetic route is employed; raw material is cheap and available, so that both the process and manufacturing cost can be reduced.

The above fluorene-containing difluoro benzotriazolyl copolymer can be used as electron donor materials of the active layer of organic solar cells.

In order to make the present invention clearer, further description of the present invention, specifically the preparation of material and device will be illustrated, which combined with embodiments and the drawings. It will be understood that the embodiments are illustrative and that the invention scope is not so limited. Monomer of compound A herein can be purchased in the market, monomer of compound B can be synthesized referring to the method disclosed in the reference (J. Am. Chem. Soc. 2011,133,4625) or purchased from the market.

### Example 1

The fluorene-containing difluoro benzotriazolyl copolymer, i.e. poly{9, 9-di-n-hexyl-2,7-fluorene-co-2-n-octyl-4,7-dithienyl-5,6-difluoro benzotriazole} having a structure represented by the following formula was prepared in the Example 1, wherein R₁ was n-hexyl, R₂ was n-octyl, n was 70.

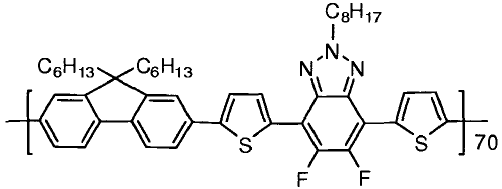

The polymer was prepared as follows.

The reaction equation is:

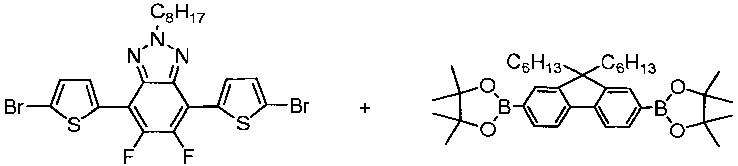

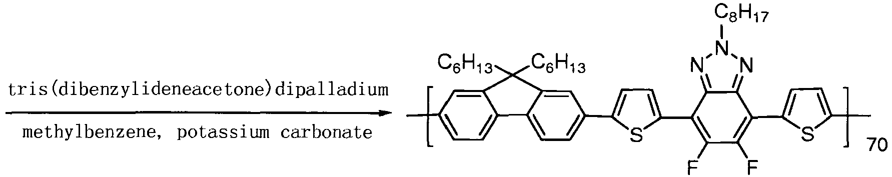

To a flask containing 12 mL of methylbenzene, mixture of 2, 7-bis(boronic acid pinacol ester)-9,9-di-n-hexyl fluorene (176 mg, 0.3 mmol), 2-n-octyl-4, 7-bis(5-bromothienyl)-5,6-difluoro-1, 2, 3-benzotriazole (176.8 mg, 0.3 mmol), tris(dibenzylideneacetone)dipalladium (13.75 mg, 0.015mmol) and tri-tert-butylphosphine (i.e. 2-dicyclohexylphosphino-2',6'-dimethoxybiphenyl) (2 mg) was added and dissolved to make a solution. Then potassium carbonate solution (3 mL, 2mol/L) was added into the solution. After supplying nitrogen to the flask to expel air for 30 min, Suzuki coupling reaction was carried out for 48 h while stirring at 95°C. The polymerization reaction was stopped after cooling. And then reaction liquid was obtained.

40 mL of methanol was added into the flask to precipitate the reaction liquid. Then the reaction liquid was filtered with Soxhlet extractor, followed by extraction with methanol and n-hexane successively for 24 h; then using chloroform as an extractant to extract until the reaction solution became colorless. Chloroform solution was collected and evaporated to give red powders. The red powders were then dried at 50°C under vacuum for 24 h to obtain final product, i.e. poly{9, 9-di-n-hexyl-2,7-fluorene-co-2-n-octyl-4,7-dithienyl-5,6-difluoro benzotriazole}. The yield is 75%.

The test results were: Molecular weight (GPC, THF, R. I): Mₙ =48.1 kDa, M_{w}/Mₙ =2.0.

Fig. 2 is a UV-VIS absorption spectra of poly{9, 9-di-n-hexyl-2,7-fluorene-co-2-n-octyl-4,7-dithienyl-5,6-difluoro benzotriazole} prepared in Example 1; it can be seen from Fig. 2 that a relatively strong absorption peak appears at around 680 nm.

### Example 2

The fluorene-containing difluoro benzotriazolyl copolymer, i.e. poly{9, 9-dimethyl-2,7-fluorene-co-2-n-eicosyl-4,7-dithienyl-5,6-difluoro benzotriazole} having a structure represented by the following formula was prepared in the Example 2, wherein R₁ was methyl, R₂ was n-eicosyl, n was 50.

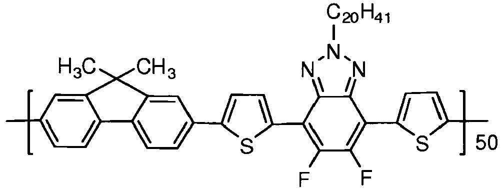

The polymer was prepared as follows.

The reaction equation is:

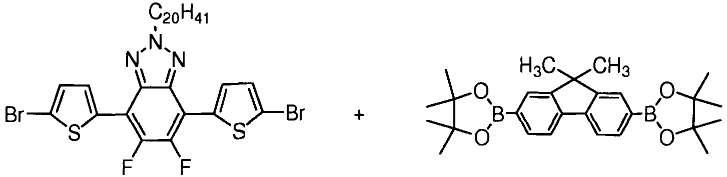

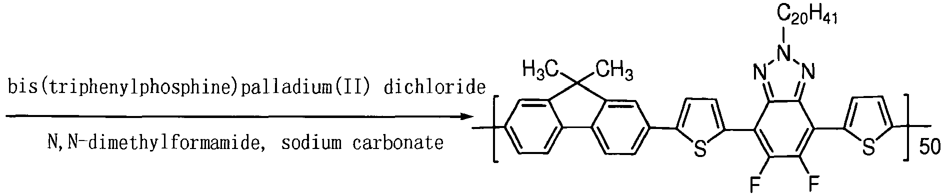

To a flask containing 15 mL of N,N-dimethylformamide solvent, mixture of 2, 7-bis(boronic acid pinacol ester)-9,9-dimethyl fluorene (89 mg, 0.2mmol) and 2-n-eicosyl-4,7-bis(5-bromothienyl)-5,6-difluoro-1,2,3-1H-benzotriazole (151.4 mg, 0.2mmol) was added and dissolved to make a solution. Then sodium carbonate solution (2 mL, 2mol/L) was added into the solution. After vacuumizing to expel oxygen and supplying argon to the flask, 5 mg of bis(triphenylphosphine)palladium(II) dichloride was added. The temperature was elevated to 110°C. Suzuki coupling reaction was carried out for 24 h while stirring. The polymerization reaction was stopped after cooling. And then reaction liquid was obtained.

50 mL of methanol was added into the flask to precipitate the reaction liquid. Then the reaction liquid was filtered with Soxhlet extractor, followed by extraction with methanol and n-hexane successively for 24 h; then using chloroform as an extractant to extract until the reaction solution became colorless. Chloroform solution was collected and evaporated to give red powders. The red powders were then dried at 50°C under vacuum for 24 h to obtain final product, i.e. poly{9, 9-dimethyl-2,7-fluorene-co-2-n-eicosyl-4,7-dithienyl-5,6-difluoro benzotriazole}. The yield is 77%.

The test results were: Molecular weight (GPC, THF, R. I): Mₙ = 39.5 kDa, M_{w}/Mₙ =2.1.

### Example 3

The fluorene-containing difluoro benzotriazolyl copolymer, i.e. poly{9, 9-di-n-eicosyl-2,7-fluorene-co-2-methyl-4,7-dithienyl-5,6-difluoro benzotriazole} having a structure represented by the following formula was prepared in the Example 3, wherein R₁ was n-eicosyl, R₂ was methyl, n was 58.

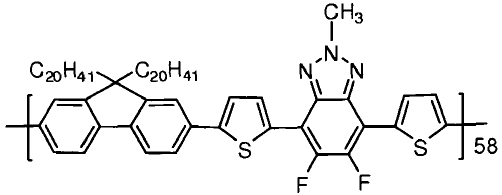

The polymer was prepared as follows.

The reaction equation is:

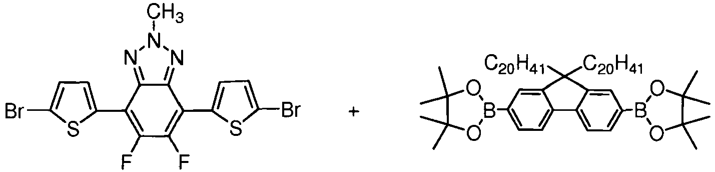

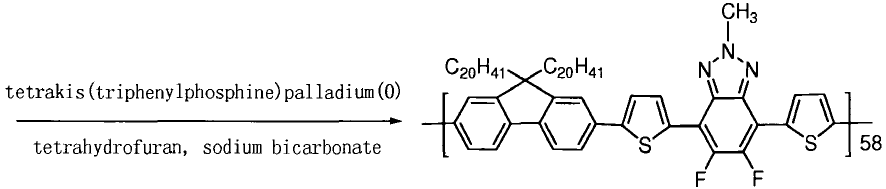

To a 50 mL-two-necked flask containing 15 mL of tetrahydrofuran, mixture of 2, 7-bis(boronic acid pinacol ester)-9,9-di-n-eicosyl fluorene (294 mg, 0.3 mmol), 2-methyl-4,7-bis(5-bromothienyl)-5,6-difluoro-1, 2, 3-1H-benzotriazole (147.3 mg, 0.3 mmol) was added and dissolved to make a solution. Then sodium bicarbonate solution (3 mL, 2mol/L) was added into the solution. After supplying mixed gases of nitrogen and argon to expel air for 20 min, 17 mg of tetrakis(triphenylphosphine)palladium(0) was added into the two-necked flask, followed by continued supply of mixed gases of nitrogen and argon to expel air for about 10 min. Suzuki coupling reaction was carried out for 72 h while stirring at 80°C. The reaction liquid was obtained.

40 mL of methanol was added into the flask to precipitate the reaction liquid. Then the reaction liquid was filtered with Soxhlet extractor, followed by extraction with methanol and n-hexane successively for 24 h; then using chloroform as an extractant to extract until the reaction solution became colorless. Chloroform solution was collected and evaporated to give red powders. The red powders were then dried at 50°C under vacuum for 24 h to obtain final product, i.e. poly{9, 9-di-n-eicosyl-2,7-fluorene-co-2-methyl-4,7-dithienyl-5,6-difluoro benzotriazole}. The yield is 72%.

The test results were: Molecular weight (GPC, THF, R. I): Mₙ = 61.3 kDa, M_{w}/Mₙ =2.0.

### Example 4

The fluorene-containing difluoro benzotriazolyl copolymer, i.e. poly{9, 9-di-n-hexyl-2,7-fluorene-co-2-n-dodecyl-4,7-dithienyl-5,6-difluoro benzotriazole} having a structure represented by the following formula was prepared in the Example 4, wherein R₁ was n-hexyl, R₂ was n-dodecyl, n was 10.

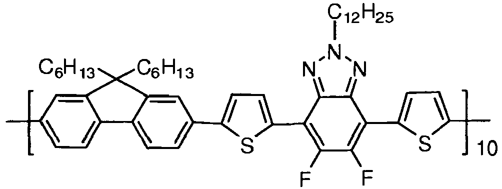

The polymer was prepared as follows.

The reaction equation is:

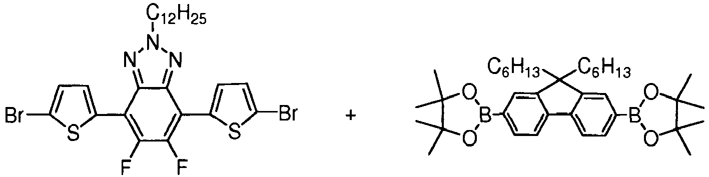

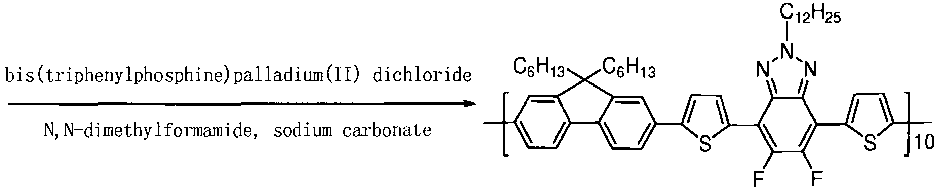

To a flask containing 15 mL of N,N-dimethylformamide solvent, mixture of 2, 7-bis(boronic acid pinacol ester)-9,9-di-n-hexyl fluorene (117 mg, 0.2mmol), 2-n-dodecyl-4,7-bis(5-bromothienyl)-5,6-difluoro-1,2,3-1H-benzotriazole (128.6 mg, 0.2mmol) was added and dissolved to make a solution. Then sodium carbonate solution (2 mL, 2mol/L) was added into the solution. After vacuumizing to expel oxygen and supplying argon to the flask, bis(triphenylphosphine)palladium(II) dichloride (0.01 mmol, 7.02 mg) was added. The temperature was elevated to 130°C. Suzuki coupling reaction was carried out for 12 h. The polymerization reaction was stopped after cooling. And then reaction liquid was obtained.

50 mL of methanol was added into the flask to precipitate the reaction liquid. Then the reaction liquid was filtered with Soxhlet extractor, followed by extraction with methanol and n-hexane successively for 24 h; then using chloroform as an extractant to extract until the reaction solution became colorless. Chloroform solution was collected and evaporated to give red powders. The red powders were then dried at 50°C under vacuum for 24 h to obtain final product, i.e. poly{9, 9-di-n-hexyl-2,7-fluorene-co-2-n-dodecyl-4,7-dithienyl-5,6-difluoro benzotriazole}. The yield is 71 %.

The test results were: Molecular weight (GPC, THF, R. I): Mₙ = 10.7 kDa, M_{w}/Mₙ =2.3.

### Example 5

The fluorene-containing difluoro benzotriazolyl copolymer, i.e. poly {9, 9-di-n-decyl-2,7-fluorene-co-2-n-tetradecyl-4,7-dithienyl-5,6-difluoro benzotriazole} having a structure represented by the following formula was prepared in the Example 2, wherein R₁ was n-decyl, R₂ was n-tetradecyl, n was 100.

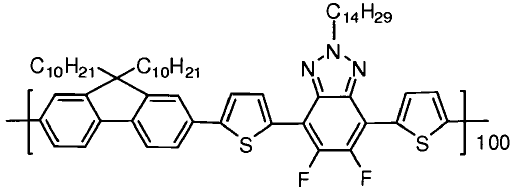

The polymer was prepared as follows.

The reaction equation is:

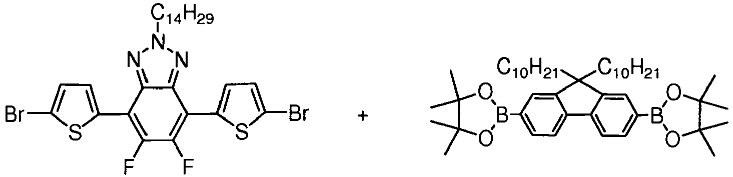

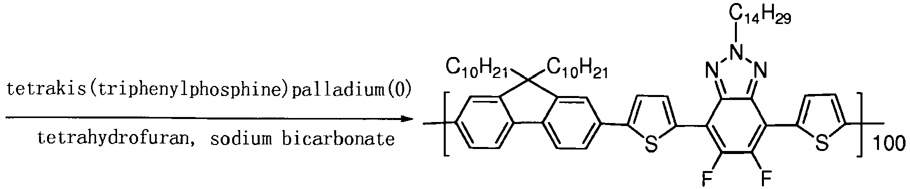

To a 50 mL-two-necked flask containing 15 mL of tetrahydrofuran, mixture of 2, 7-bis(boronic acid pinacol ester)-9,9-di-n-decyl fluorene (294 mg, 0.3 mmol), 2-n-tetradecyl-4,7-bis(5-bromothienyl)-5,6-difluoro-1, 2, 3-1H-benzotriazole (147.3 mg, 0.3 mmol) was added and dissolved to make a solution. Then sodium bicarbonate solution (3 mL, 2mol/L) was added into the solution. After supplying mixed gases of nitrogen and argon to expel air for 20 min, tetrakis(triphenylphosphine)palladium(0) (0.003 mmol, 3.7 mg) was added into the two-necked flask, followed by continued supply of mixed gases of nitrogen and argon to expel air for about 10 min. Suzuki coupling reaction was carried out for 96 h while stirring at 70°C. The reaction liquid was obtained.

40 mL of methanol was added into the flask to precipitate the reaction liquid. Then the reaction liquid was filtered with Soxhlet extractor, followed by extraction with methanol and n-hexane successively for 24 h; then using chloroform as an extractant to extract until the reaction solution became colorless. Chloroform solution was collected and evaporated to give red powders. The red powders were then dried at 50°C under vacuum for 24 h to obtain final product, i.e. poly{9, 9-di-n-decyl-2,7-fluorene-co-2-n-tetradecyl-4,7-dithienyl-5,6-difluoro benzotriazole}. The yield is 85%.

The test results were: Molecular weight (GPC, THF, R. I): Mₙ = 95.8 kDa, M_{w}/Mₙ =1.9.

### Example 6

Organic solar cell was prepared in Example 6 by using the poly{9, 9-di-n-hexyl-2,7-fluorene-co-2-n-octyl-4,7-dithienyl-5,6-difluoro benzotriazole} (i.e. DFBTz-F1) obtained in Example 1 as electron donor material of active layer.

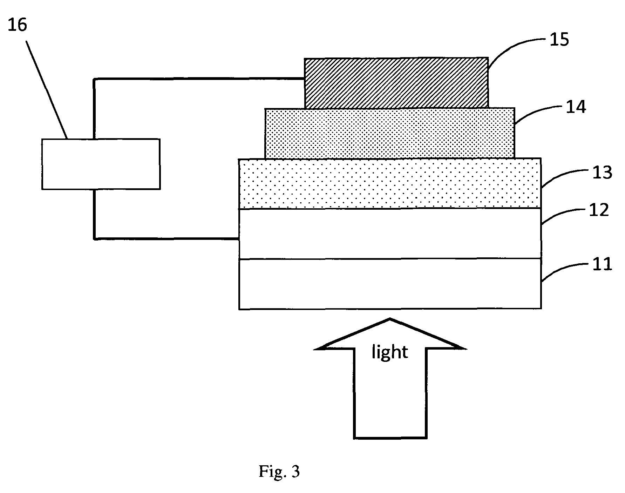

Referring to Fig. 3, the organic solar cell comprises glass substrate 11, transparent anode 12, auxiliary layer 13, active layer 14 and cathode 15 stacked in sequence. Transparent anode 12 can be indium tin oxide (abbr. ITO), preferably ITO having square resistance of 10∼20Ω/□; Auxiliary layer 13 can be the composite material of poly(3,4-ethylenedioxythiophene)-poly(styrene sulfonate) (abbr. PEDOT:PSS). Active layer 14 comprises electron donor material and electron acceptor material. Herein, electron donor material was polymer (i.e. DFBTz-F1) obtained from Example 1, electron acceptor material can be [6,6]-phenyl-C₆₁-butyric acid methyl ester (abbr. PCBM); Cathode 15 can be aluminium electrode or double-layer metal electrode, such as Ca/Al or Ba/Al. The thickness was preferably 170 nm, 30 nm, 130 nm or 60 nm.

Glass substrate 11 can be served as the base at the bottom. In the manufacturing process, ITO glass was ultrasonically cleaned, followed by Oxygen-Plasma treatment. Auxiliary layer 13 was coated on the ITO glass. The polymer obtained from Example 1 was blended together with electron acceptor material then coated on the auxiliary layer 13 to form active layer 14. Cathode 15 was deposited on the active layer 14 by vacuum coating technique to obtain the organic solar cell. The organic solar cell needs to be heated at 110 degrees centigrade in a sealed condition for 4 h, and then cooled to room temperature. Because the order and regularity of radicals and chain segments can get improved after annealing, so that the transporting speed and transporting efficiency of carrier are enhanced, resulting in the improvement of photoelectric conversion efficiency. In this embodiment, thickness of cathode 15 Al layer was 170 nm.

As shown in Fig. 3, in the light, the light goes through glass substrate 11 and ITO electrode 12. Hole-conducting type electroluminescent material of active layer 14 absorbs solar energy, and generates excitons. The excitons migrate to the interface of electron donor / acceptor materials, and transfer electrons to the electron acceptor material, such as PCBM, achieving in charge separation and thus forming free carriers, namely, free electrons and holes. These free electrons pass along the electron acceptor material to the metal cathode and are collected by cathode; free holes pass along electron donor material to the ITO anode and are collected by anode to generate photocurrent and photovoltage, achieving photon-to-electron conversion. When it connects to load 16, it can be supplied with power. In this process, because of its very wide wavelength range of spectrum response, hole-conducting type electroluminescent material is able to make better use of solar energy, obtain a higher photon-to-electron conversion efficiency, and increase the electricity production capacity of solar cell devices. And this organic material can reduce quality of solar cell devices, and can be produced by spin coating, facilitate to manufacture on a large scale.

Table 1 shows photovoltaic properties of organic solar cell prepared in Example 6. (note: PCE stands for power conversion efficiency; V_{oc} stands for open-circuit voltage,; J_{sc} stands for short-circuit current; FF stands for fill factor.)

**Table 1**

| | V_{oc}(V) | J_{sc}(mA/cm²) | FF (%) | PCE(%) |
|---|---|---|---|---|
| DFBTz-F1/PCBM | 0.70 | 10.7 | 54.5 | 4.1 |

Results in Table 1 indicate that in the AM1.5 and 100mW/cm² light, power conversion efficiency of the bulk heterojunction solar cell using DFBTz-F1 as electron donor material is 4.1%; AM herein stands for air mass, which is the optical path length through Earth's atmosphere for sunlight, expressed as a ratio relative to zenith path length at sea level; condition of AM 1.5 means remarking and measuring the ground under the rated irradiance and spectral distribution of solar cell. The total solar irradiance is 1000 watts per square meter, the temperature of solar cell is 25°C; this standard which also currently applies in China is set by International Electrotechnical Commission. Specifically, a standard irradiance intensity of sun is equivalent to that of an AM 1.5G standard light source. AM 1.5G means a beam of sunlight having a zenith angle (the angle between a direction of incident light and the normal to the Earth's surface) of 48°, light intensity is 1000 W/m² (i.e. AM1.5 and 100 mW/cm² light).

While the present invention has been described with reference to particular embodiments, it will be understood that the embodiments are illustrative and that the invention scope is not so limited. Alternative embodiments of the present invention will become apparent to those having ordinary skill in the art to which the present invention pertains. Accordingly, the scope of the present invention is described by the appended claims and is supported by the foregoing description.

## Claims

1. A fluorene-containing difluoro benzotriazolyl copolymer, wherein having a structure represented by the following formula (I): 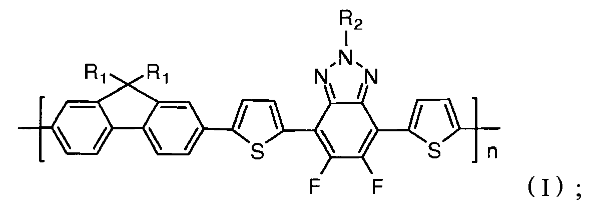 wherein R₁ and R₂ are alkyls from C₁ to C₂₀, and n is an integer from 10 to 100.

2. The fluorene-containing difluoro benzotriazolyl copolymer according to claim 1, wherein n is in the range of 50 to 70.

3. A method for preparing fluorene-containing difluoro benzotriazolyl copolymer, comprising:
S1, providing compound A and compound B represented by the following formulas, separately; 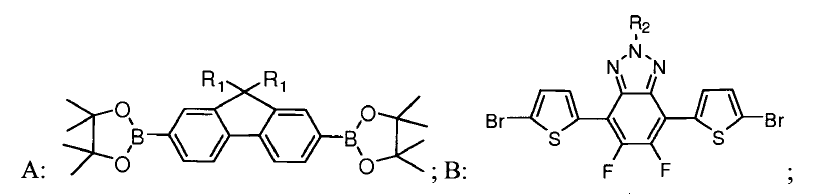 wherein in said compound A, R₁ is alkyl from C₁ to C₂₀; in said compound B, R₂ is alkyl from C₁ to C₂₀;
S2, in an oxygen-free environment, adding said compound A and compound B in a molar ratio of 1:1 into organic solvent containing catalyst and alkaline solution, carrying out Suzuki coupling reaction at a temperature in the range of 70 to 130°C for 12 to 96 h, then obtaining fluorene-containing difluoro benzotriazolyl copolymer having a structure represented by the following formula (I): 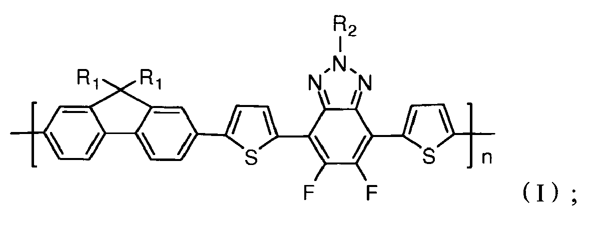 wherein n is an integer from 10 to 100.

4. The method for preparing fluorene-containing difluoro benzotriazolyl copolymer according to claim 3, wherein further comprising:
S3, purifying the fluorene-containing difluoro benzotriazolyl copolymer obtained in S2.

5. The method for preparing fluorene-containing difluoro benzotriazolyl copolymer according to claim 3 or 4, wherein in said S2, said catalyst is organopalladium or mixture of organopalladium and organic phosphorus ligand.

6. The method for preparing fluorene-containing difluoro benzotriazolyl copolymer according to claim 5, wherein in said S2, molar ratio of said organopalladium to said compound A is in the range of 1:20∼1:100.

7. The method for preparing fluorene-containing difluoro benzotriazolyl copolymer according to claim 3 or 4, wherein in said S2, said organic solvent comprises at least one solvent selected from the group consisting of methylbenzene, N,N-dimethylformamide and tetrahydrofuran.

8. The method for preparing fluorene-containing difluoro benzotriazolyl copolymer according to claim 3 or 4, wherein in said S2, said alkaline solution comprises at least one alkaline solution selected from the group consisting of sodium carbonate solution, potassium carbonate solution and sodium bicarbonate solution.

9. The method for preparing fluorene-containing difluoro benzotriazolyl copolymer according to claim 3 or 4, wherein in said S2, said Suzuki coupling reaction is carried out at a temperature in the range of 80 to 110°C for 24 to 72 h.

10. Uses of the fluorene-containing difluoro benzotriazolyl copolymer according to claim 1 in organic solar cells.

## Patentansprüche

1. Fluorenhältiges Difluorbenzotriazolylcopolymer mit einer Struktur der folgenden Formel (I): 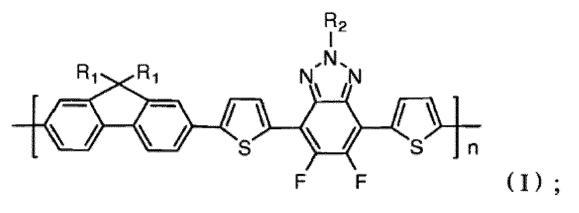 worin R₁ und R₂ C₁-C₂₀-Alkyle sind und n eine ganze Zahl von 10 bis 100 ist.

2. Fluorenhältiges Difluorbenzotriazolylcopolymer nach Anspruch 1, worin n im Bereich von 50 bis 70 liegt.

3. Verfahren zur Herstellung eines fluorenhältigen Difluorbenzotriazolylcopolymers, das Folgendes umfasst:
S1, separates Bereitstellen einer Verbindung A und einer Verbindung B der folgenden Formeln: 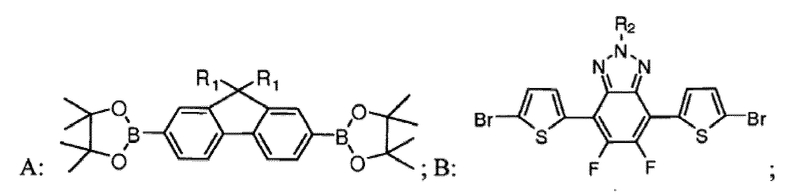 wobei R₁ in Verbindung A ein C₁-C₂₀-Alkyl ist; und R₂ in Verbindung B ein C₁-C₂₀-Alkyl ist;
S2, Zusetzen der Verbindung A und der Verbindung B in einem Molverhältnis von 1:1 in einer sauerstofffreien Umgebung zu einem organischen Lösungsmittel, das einen Katalysator und eine alkalische Lösung enthält, Ausführung einer SuzukiKupplungsreaktion bei einer Temperatur im Bereich von 70 bis 130 °C 12 bis 96 h lang, dann Erhalten eines fluorenhältigen Difluorbenzotriazolylcopolymers mit einer Struktur der folgenden Formel (I): 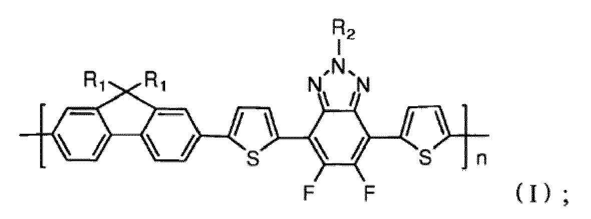 worin n eine ganze Zahl von 10 bis 100 ist.

4. Verfahren zur Herstellung eines fluorenhältigen Difluorbenzotriazolylcopolymers nach Anspruch 3, das weiters Folgendes umfasst:
S3, Reinigen des in S2 erhaltenen fluorenhältigen Difluorbenzotriazolylcopolymers.

5. Verfahren zur Herstellung eines fluorenhältigen Difluorbenzotriazolylcopolymers nach Anspruch 3 oder 4, wobei in S2 der Katalysator Organopalladium oder ein Gemisch aus Organopalladium und einem organischen Phosphorliganden ist.

6. Verfahren zur Herstellung eines fluorenhältigen Difluorbenzotriazolylcopolymers nach Anspruch 5, wobei in S2 das Molverhältnis zwischen dem Organopalladium und der Verbindung A im Bereich von 1:20-1:100 liegt.

7. Verfahren zur Herstellung eines fluorenhältigen Difluorbenzotriazolylcopolymers nach Anspruch 3 oder 4, wobei in S2 das organische Lösungsmittel zumindest ein Lösungsmittel umfasst, das aus der aus Methylbenzol, N,N-Dimethylformamid und Tetrahydrofuran bestehenden Gruppe ausgewählt ist.

8. Verfahren zur Herstellung eines fluorenhältigen Difluorbenzotriazolylcopolymers nach Anspruch 3 oder 4, wobei in S2 die alkalische Lösung zumindest eine alkalische Lösung umfasst, die aus der aus Natriumcarbonatlösung, Kaliumcarbonatlösung und Natriumbicarbonatlösung bestehenden Gruppe ausgewählt ist.

9. Verfahren zur Herstellung eines fluorenhältigen Difluorbenzotriazolylcopolymers nach Anspruch 3 oder 4, wobei in S2 die Suzuki-Kupplungsreaktion bei einer Temperatur im Bereich von 80 bis 110 °C 24 bis 72 h lang ausgeführt wird.

10. Verwendung des fluorenhältigen Difluorbenzotriazolylcopolymers nach Anspruch 1 in organischen Solarzellen.

## Revendications

1. Copolymère de difluorobenzotriazolyle contenant du fluorène, ayant une structure représentée par la formule (I) suivante : 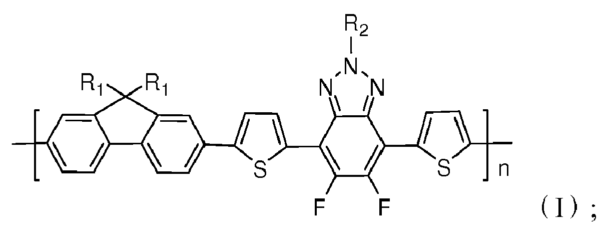 dans laquelle R₁ et R₂ sont des radicaux alkyle en C₁ à C₂₀, et n est un entier de 10 à 100.

2. Copolymère de difluorobenzotriazolyle contenant du fluorène selon la revendication 1, dans lequel n est situé dans la plage allant de 50 à 70.

3. Procédé pour préparer un copolymère de difluorobenzotriazolyle contenant du fluorène, comprenant :
S1 : l'obtention d'un composé A et d'un composé B représentés par les formules suivantes, séparément : 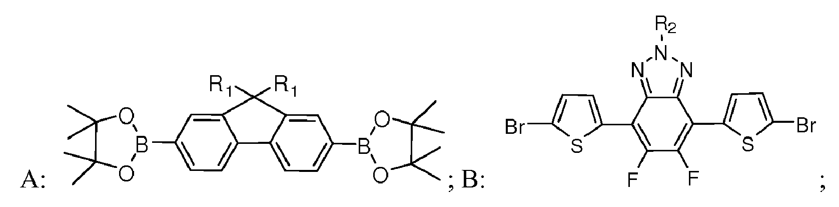 où, dans ledit composé A, R₁ est un radical alkyle en C₁ à C₂₀ ; dans ledit composé B, R₂ est un radical alkyle en C₁ à C₂₀ ;
S2 : dans un environnement sans oxygène, l'addition desdits composé A et composé B en un rapport molaire de 1/1 dans un solvant organique contenant un catalyseur et une solution alcaline, la mise en oeuvre d'une réaction de couplage de Suzuki à une température située dans la plage allant de 70 à 130°C pendant 12 à 96 heures, puis l'obtention d'un copolymère de difluorobenzotriazolyle contenant du fluorène ayant une structure représentée par la formule (I) suivante : 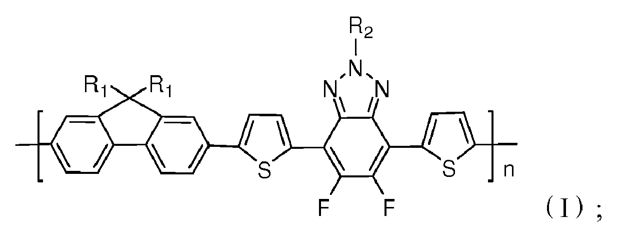 dans laquelle n est un entier de 10 à 100.

4. Procédé pour préparer un copolymère de difluorobenzotriazolyle contenant du fluorène selon la revendication 3, comprenant en outre :
S3, la purification du copolymère de difluorobenzotriazolyle contenant du fluorène obtenu en S2.

5. Procédé pour préparer un copolymère de difluorobenzotriazolyle contenant du fluorène selon la revendication 3 ou 4, dans lequel, dans ladite étape S2, ledit catalyseur est un composé organique du palladium ou un mélange d'un composé organique du palladium et d'un ligand phosphoré organique.

6. Procédé pour préparer un copolymère de difluorobenzotriazolyle contenant du fluorène selon la revendication 5, dans lequel, dans ladite étape S2, le rapport molaire dudit composé organique du palladium audit composé A est situé dans la plage allant de 1/20 à 1/100.

7. Procédé pour préparer un copolymère de difluorobenzotriazolyle contenant du fluorène selon la revendication 3 ou 4, dans lequel, dans ladite étape S2, ledit solvant organique comprend au moins un solvant choisi dans le groupe constitué par le méthylbenzène, le N,N-diméthylformamide et le tétrahydrofurane.

8. Procédé pour préparer un copolymère de difluorobenzotriazolyle contenant du fluorène selon la revendication 3 ou 4, dans lequel, dans ladite étape S2, ladite solution alcaline comprend au moins une solution alcaline choisie dans le groupe constitué par une solution de carbonate de sodium, une solution de carbonate de potassium et une solution de bicarbonate de sodium.

9. Procédé pour préparer un copolymère de difluorobenzotriazolyle contenant du fluorène selon la revendication 3 ou 4, dans lequel, dans ladite étape S2, ladite réaction de couplage de Suzuki est mise en oeuvre à une température située dans la plage allant de 80 à 110°C pendant 24 à 72 heures.

10. Utilisation du copolymère de difluorobenzotriazolyle contenant du fluorène selon la revendication 1 dans des cellules solaires organiques.
